# EUROPEAN PATENT APPLICATION

(11) **EP 4 844 426 A1**
(43) Date of publication of application: **25.11.2026**
(21) Application number: 26172647.5
(22) Date of filing: 16.04.2026
(51) Int. Cl.: G01R 31/385, H01M 10/44, H01M 50/572

(54) **METHODS FOR PROCESSING AND MANUFACTURING SECONDARY BATTERY**

(30) Priority: 19.05.2025 JP 2025083590
(71) Applicant: Prime Planet Energy & Solutions, Inc., Chuo-ku, Tokyo 103-0022 (JP)
(72) Inventor: KARAKI, Hitoshi, Tokyo 103-0022 (JP)
(74) Representative: Kuhnen & Wacker Patent- und Rechtsanwaltsbüro PartG mbB

(57) **Abstract**

A method for processing a secondary battery disclosed herein is a method for processing a battery (secondary battery) including an electrode body, a non-aqueous electrolytic solution, and a case housing these component. The electrode body includes a laminated structure of a positive electrode, a negative electrode, and a separator interposed therebetween. The method for processing the secondary battery includes a cutting step. In the cutting step, a minute short circuit portion extending between the positive electrode and the negative electrode inside the electrode body is cut by changing an inter-electrode distance between the positive electrode and the negative electrode.

## Description

### BACKGROUND

The present invention relates to methods for processing and manufacturing a secondary battery.

In recent years, secondary batteries such as lithium-ion secondary batteries capable of being repeatedly charged and discharged have been used as portable power supplies for mobile terminals and as power supplies for driving vehicles such as electric vehicles (EVs), hybrid electric vehicles (HEVs), and plug-in hybrid electric vehicles (PHEVs). For example, a secondary battery includes an electrode body including electrodes (positive electrode, negative electrode) responsible for battery reactions during charging and discharging, a non-aqueous electrolytic solution, and a case housing these components. For example, the electrode body includes a laminated structure in which positive electrodes and negative electrodes are alternately disposed with separators interposed therebetween.

During the manufacturing process of such secondary batteries, the battery is inspected for the presence of a minute short circuit between the positive and negative electrodes, for example, by measuring the open circuit voltage of the battery, and secondary batteries in which a minute short circuit is confirmed are discarded. The minute short circuit may occur when fine metal powder mixed into the electrode body from the outside during the fabricating process of the electrode body passes through the separator to form a conductive path connecting between the electrodes. The minute short circuit may also occur when, during repeated charging and discharging of secondary batteries that have already been assembled, metals dissolved in the non-aqueous electrolytic solution (derived from the metal powder or the electrode body component materials), for example, precipitate and grow on the negative electrode and then reach the positive electrode. A technique for suppressing such a minute short circuit in a secondary battery is disclosed in, for example, Japanese Patent Application Laid-Open No. 2022-140953.

### SUMMARY

The technology disclosed in Japanese Patent Application Laid-Open No. 2022-140953 is not a technology for eliminating minute short circuits occurring in secondary batteries that have already been assembled.

The present invention has been conceived under such circumstances, and an object of the present invention is to provide methods for processing and manufacturing a secondary battery suitable for eliminating minute short circuits occurring in the secondary battery that has already been assembled.

A method for processing a secondary battery disclosed herein is a method for processing a secondary battery, the secondary battery including an electrode body, a non-aqueous electrolytic solution, and a case housing the electrode body and the non-aqueous electrolytic solution. The electrode body includes a laminated structure of a positive electrode, a negative electrode, and a separator interposed between the positive electrode and the negative electrode. This processing method includes a cutting step. In the cutting step, a minute short circuit portion extending between the positive electrode and the negative electrode inside the electrode body is cut by changing an inter-electrode distance between the positive electrode and the negative electrode.

In the cutting step of the secondary battery processing method configured as described above, the minute short circuit portion extending between the positive electrode and the negative electrode inside the electrode body is cut by changing the inter-electrode distance between the positive electrode and the negative electrode. Such a cutting step is suitable for interrupting a conductive path formed, due to the minute short circuit portion, between electrodes (positive electrode and negative electrode) by cutting the minute short circuit portion. Such an interruption of the conductive path is suitable for eliminating the minute short circuit in the secondary battery that has already been assembled.

### BRIEF DESCRIPTION OF THE DRAWINGS

FIG. 1 is a cross-sectional diagram schematically showing an internal structure of a secondary battery, which is an example targeted for the method of processing the secondary battery according to the present invention;
FIG.2 is a schematic diagram showing a configuration of an electrode body included in the secondary battery shown in FIG. 1;
FIG. 3 is a flowchart of a method for processing the secondary battery, which is one embodiment of the present invention;
FIG.4 is a flow chart showing one embodiment of a cutting step;
FIG.5 is a flow chart showing another embodiment of the cutting step; and
FIG.6 is a graph showing a difference in open circuit voltages between a battery cell occurring no minute short circuit and a battery cell occurring a minute short circuit.

### DETAILED DESCRIPTION

Hereinafter, as one embodiment of the method for processing a secondary battery according to the present invention, a method for processing a lithium ion secondary battery will now be described with reference to the drawings. The term "secondary battery" used herein generally means a power storage device that can be repeatedly charged and discharged. The present invention can be implemented on the basis of the contents disclosed herein and the common general technical knowledge in the art. Matters other than those specifically described herein that are necessary for implementing the present invention (e.g., the general configuration and manufacturing process of a secondary battery that does not characterize the present invention) can be understood as design matters for a person skilled in the art based on conventional technology in the art.

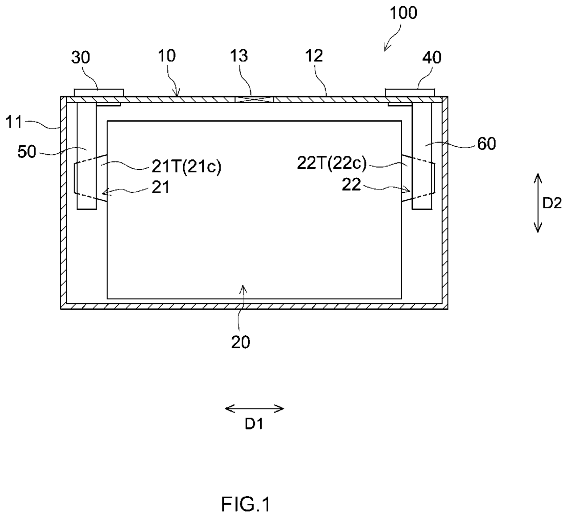

FIG. 1 is a cross-sectional diagram schematically showing an internal structure of a battery 100, which is an example targeted for the method of processing the secondary battery according to the present invention. The battery 100 includes a case 10, an electrode body 20, a positive electrode terminal 30, a negative electrode terminal 40 and a non-aqueous electrolytic solution (not shown). In this embodiment, the battery 100 is a lithium ion secondary battery.

The case 10 is a housing of the battery 100 and houses the electrode body 20 and the non-aqueous electrolytic solution. The case 10 includes a case body 11 and a sealing plate 12, in the present embodiment. In the present embodiment, the case 10 or the case body 11 has a flat, rectangular parallelepiped shape (e.g., square shape), which is a shape extending in a first direction D1. In the present embodiment, the case 10 or the case body 11 has a height in a second direction D2, which is a direction perpendicular to the first direction D1, and has a thickness in a direction perpendicular to the first direction D1 and the second direction D2. The case body 11 includes an opening at an upper end in the height direction, in the drawing. The sealing plate 12 seals the opening. Examples of component materials that can be used to form the case 10 include aluminum, aluminum alloys, iron, and iron alloys.

The case 10 includes a safety valve 13. In the present embodiment, the safety valve 13 is positioned between the positive electrode terminal 30 and the negative electrode terminal 40 on the sealing plate 12. The safety valve 13 is a thin wall portion configured to break when pressure inside the case 10 exceeds a predetermined value. Moreover, the case 10 includes a liquid injection hole (not shown) for injecting the non-aqueous electrolytic solution into the case 10. The liquid injection hole is sealed by a sealing member after the injection of the non-aqueous electrolytic solution.

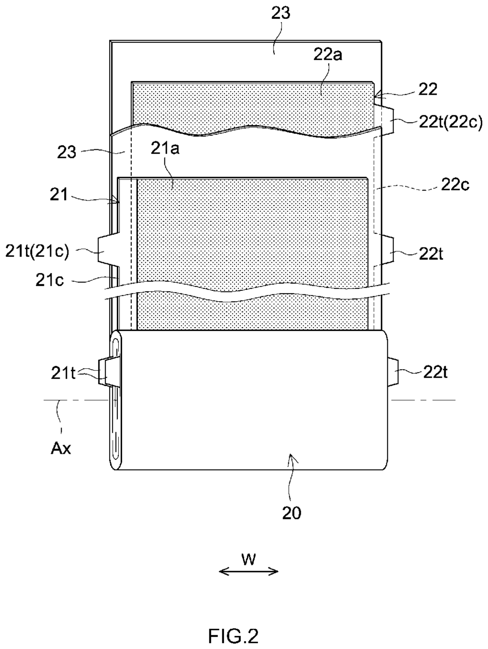

FIG.2 is a schematic diagram showing a configuration of the electrode body 20. The electrode body 20 includes a laminated structure of a positive electrode 21, a negative electrode 22, and a separator 23 interposed therebetween. In this embodiment, the electrode body 20 is a flat wound electrode body, and is formed by winding a long sheet-shaped laminated body (having a width in a direction perpendicular to its longitudinal direction) in which the long sheet-shaped positive electrode 21, the long sheet-shaped separator 23, the long sheet-shaped negative electrode 22, and the further long sheet-shaped separator 23 are disposed in this order. After winding, the wound electrode body may be flattened by being pressed. Such an electrode body 20 (wound electrode body) is housed in the case 10 so that a winding axis Ax thereof extends in the first direction D1 in FIG. 1. Instead of the above-described configuration, the electrode body 20 may be a laminated electrode body, which is obtained by laminating a rectangular positive electrode and a rectangular negative electrode in a state insulated from each other. Alternatively, a plurality of electrode bodies 20 may be housed in the case 10 so as to be disposed in the thickness direction of the case 10.

The positive electrode 21 has a laminated structure including a positive electrode current collector 21c and a positive electrode active material layer 21a. In the present embodiment, the positive electrode 21 has the positive electrode active material layer 21a on both sides of the positive electrode current collector 21c (not shown). The positive electrode current collector 21c is, for example, a strip-shaped conductive metal foil. Examples of component materials for the positive electrode current collector 21c include aluminum and aluminum alloys. The positive electrode active material layer 21a includes a positive electrode active material capable of reversibly absorbing and releasing charge carriers. Examples of such a positive electrode active material include lithium cobalt composite oxide, lithium manganese composite oxide, lithium nickel composite oxide, lithium nickel manganese composite oxide, lithium nickel cobalt composite oxide, and lithium nickel cobalt manganese composite oxide. The positive electrode active material layer 21a may contain an additive component other than the positive electrode active material as needed. Examples of such an additive component include, for example, a conductive material, a binder, and trilithium phosphate. Examples of the conductive material include acetylene black, ketjen black, graphite, and carbon nanotubes. Examples of the binder include fluorine-based resins such as polyvinylidene fluoride (PVDF) and rubbers such as styrene butadiene rubber (SBR).

The positive electrode current collector 21c includes a plurality of tabs 21t at one end (left end in FIG. 2) in a width direction W of the electrode body 20. The width direction W is a direction perpendicular to the longitudinal direction of the long sheet-like laminated body. In the positive electrode current collector 21c, the tab 21t is included in a region exposed where no positive electrode active material layer 21a is laminated. In the electrode body 20, which is a wound electrode body, the plurality of tabs 21t are laminated in a laminating direction in the above-described laminated structure of the electrode body 20 to form a positive electrode tab portion 21T (shown in FIG. 1) (the tabs 21t are provided in such an arrangement in the positive electrode current collector 21c). The positive electrode tab portion 21T functions as a current collector portion of the positive electrode 21. The tabs 21t are connected to the positive electrode current collector plate 50 (shown in FIG. 1) in this laminated and integrated state (the positive electrode current collector plate 50 is provided for each positive electrode tab portion 21T). Examples of component materials for the positive electrode current collector plate 50 include aluminum and aluminum alloys. Examples of a method for connecting the positive electrode tab portion 21T of the positive electrode 21 to the positive electrode current collector plate 50 include ultrasonic bonding and laser welding.

The negative electrode 22 has a laminated structure including a negative electrode current collector 22c and a negative electrode active material layer 22a. In the present embodiment, the negative electrode 22 has the negative electrode active material layer 22a on both sides of the negative electrode current collector 22c (not shown). The negative electrode current collector 22c is preferably a strip-shaped conductive metal foil. Examples of component materials for the negative electrode current collector 22c include copper and copper alloys. The negative electrode active material layer 22a includes a negative electrode active material capable of reversibly absorbing and releasing charge carriers. Examples of the negative electrode active material include carbon materials such as graphite, hard carbon, and soft carbon. The graphite may be natural graphite or artificial graphite. The negative electrode active material layer 22a may contain an additive component other than the negative electrode active material as needed. Examples of the additive component include a binder and a thickener. Examples of the binder include rubbers such as styrene butadiene rubber (SBR) and fluorine-based resins such as polyvinylidene fluoride (PVDF). Examples of the thickener include celluloses such as carboxymethyl cellulose (CMC).

The negative electrode current collector 22c includes a plurality of tabs 22t at the other end (right end in FIG. 2) in the width direction W of the electrode body 20. In the negative electrode current collector 22c, the tab 22t is included in a region exposed where no negative electrode active material layer 22a is laminated. In the electrode body 20, which is a wound electrode body, the plurality of tabs 22t are laminated in the laminating direction in the above-described laminated structure of the electrode body 20 to form a negative electrode tab portion 22T (shown in FIG. 2) (the tabs 22t are provided in such an arrangement in the negative electrode current collector 22c). The negative electrode tab portion 22T functions as a current collecting portion in the negative electrode 22. The tabs 22t are connected to the negative electrode current collector plate 60 in this laminated and integrated state (the negative electrode current collector plate 60 is provided for each negative electrode tab portion 22T). Examples of component materials for the negative electrode current collector plate 60 (shown in FIG. 1) include copper and copper alloys. Examples of a method for connecting the negative electrode tab portion 22T of the negative electrode 22 to the negative electrode current collector plate 60 include ultrasonic bonding and laser welding.

The separator 23 is a member for insulating between the positive electrode active material layer 21a and the negative electrode active material layer 22a from each other while holding an ion-conductive electrolytic solution between both layers. The separator 23 is preferably a porous resin sheet made of polyolefin resin. Examples of the polyolefin resin include polyethylene (PE) and polypropylene (PP). On the surface of the separator 23, a heat resistance layer (HRL) containing an inorganic filler may be provided. Examples of component materials of the inorganic filler include alumina, boehmite, aluminum hydroxide, and titania.

The positive electrode terminal 30 is attached to the sealing plate 12 of the case 10 as shown in FIG. 1. For example, the sealing plate 12 has a terminal opening that passes through a component member (plate material) thereof in the thickness direction, and the positive electrode terminal 30 is attached to the opening with a gasket made of an insulating material interposed between the sealing plate 12 and the case 10. The positive electrode terminal 30 can be attached thereto by, for example, caulking. Moreover, the positive electrode terminal 30 is exposed to the outside of the case 10 and is also exposed to the inside of the case 10. In the inside of the case 10, the positive electrode terminal 30 is connected to the positive electrode current collector plate 50. The positive electrode terminal 30 is electrically connected to the positive electrode 21 of the electrode body 20 through the positive electrode current collector plate 50. Examples of component materials for the positive electrode terminal 30 include aluminum and aluminum alloys.

The negative electrode terminal 40 is also attached to the sealing plate 12 (the attachment method instruction is the same as that described above for the positive electrode terminal 30). The negative electrode terminal 40 is exposed to the outside of the case 10 and is also exposed to the inside of the case 10. In the inside of the case 10, the negative electrode terminal 40 is connected to the negative electrode current collector plate 60. The negative electrode terminal 40 is electrically connected to the negative electrode 22 of the electrode body 20 through the negative electrode current collector plate 60. Examples of component materials for the negative electrode terminal 40 include copper or copper alloys.

The non-aqueous electrolytic solution contains a non-aqueous solvent and an electrolyte (supporting salt). Examples of the non-aqueous solvent include an ethylene carbonate (EC), a propylene carbonate (PC), a dimethyl carbonate (DMC), a diethyl carbonate (DEC), and ethyl methyl carbonate (EMC). The non-aqueous solvent may be used alone or two or more kinds thereof may be used together. The electrolyte is a lithium salt, for example a fluorine-containing lithium salt. Examples of the fluorine-containing lithium salt include lithium hexafluorophosphate (LiPF₆), lithium tetrafluoroborate (LiBF₄), and lithium bis(fluorosulfonyl)imide (LiN(SO₂F)₂). The electrolyte may be used alone or two or more kinds thereof may be used together. The electrode body 20 inside the case 10 is impregnated with this non-aqueous electrolytic solution. Excess non-aqueous electrolytic solution that does not impregnate the electrode body 20 may be retained inside the case 10.

The battery 100 configured as described above is a battery that can be used for various applications. Examples of applications of the battery 100 include power sources (driving electric power source) for motors mounted on vehicles such as passenger cars, trucks, and the like. The type of vehicles is not particularly limited, but examples include plug-in hybrid electric vehicles (PHEVs), hybrid electric vehicles (HEVs), and battery electric vehicles (BEVs). Moreover, the battery 100 may be a secondary battery (power storage device) other than the lithium ion secondary battery. The secondary batteries also include batteries such as nickel metal hydride batteries, and the like.

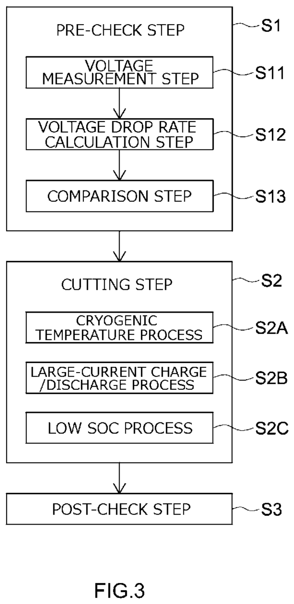

FIG. 3 is a flowchart of a method for processing the secondary battery, which is one embodiment of the present invention. The secondary battery processing method in the present embodiment includes a pre-check step S1, a cutting step S2, and a post-check step S3.

The pre-check step S1 is a step for pre-checking whether or not there is a minute short circuit in the battery 100 (an example targeted for the secondary battery processing method) and is performed before the cutting step S2. The pre-check step S1 includes a voltage measurement step S11, a voltage drop rate calculation step S12, and a comparison step S13.

In the voltage measurement step S11, for example, after adjusting the battery 100 to a predetermined charged state, the battery 100 is left standing in an open circuit state, and voltage measurements are performed on the battery 100 multiple times (two or more times). In the voltage measurement, an open circuit voltage (OCV) of the battery 100 is measured. A plurality of voltage values (OCV values) of the battery 100 are obtained during this step. An interval between voltage measurements (interval between adjacent voltage measurements in terms of time) is preferably one week or more from the viewpoint of detecting voltage fluctuations with high sensitivity. The intervals between the voltage measurements are preferably two weeks or less from the viewpoint of process efficiency.

In the voltage drop rate calculation step S12, a voltage drop rate R is calculated on the basis of the plurality of voltage values (OCV values) obtained by the multiple voltage measurements during the voltage measurement step S11. The amount of voltage drop can be calculated as a difference (δV) between the two OCV values obtained by measuring two voltages adjacent in time. The voltage drop rate R (=δV/δt) can be calculated by dividing the difference (δV) by the interval (δt) between the measurement times of the two voltage measurements. The voltage drop rate R is calculated, for example, as the amount of voltage drop per 24 hours (ΔV/24h).

In the comparison step S13, the voltage drop rate R is compared with a determination threshold value Rth. The determination threshold value Rth is a value set in advance as a voltage drop rate when the voltage drop which can be determined to be caused by a minute short circuit occurs in the battery 100. The determination threshold value Rth can be set, for example, as follows.

First, 10 batteries 100 are fabricated in which a minute short circuit is generated. The minute short circuit is generated by forming a minute short circuit portion between the positive electrode 21 and the negative electrode 22 inside the electrode body 20. Next, each of the 10 batteries 100 is self-discharged from a predetermined state of charge at a temperature of 25°C, and the OCV immediately after the start of discharge and the OCV one week after the start of discharge are measured to determine the voltage drop rate. The predetermined state of charge (SOC) is, for example, 50%, 70%, or 100%. Then, the minimum value of the 10 voltage drop rates among the 10 batteries 100 is set as the determination threshold value Rth. The determination threshold value Rth is set in accordance with the specification of the battery to be processed and is, for example, 0.50 mV/day, 0.60 mV/day, or 0.70 mV/day. A battery in which a minute short circuit is generated can be prepared, for example, by adding iron powder particles having a particle size of approximately 30 µm between the positive electrode (positive electrode 21 in this embodiment) and the separator (separator 23 in this embodiment) during the electrode body fabrication process in the battery manufacturing process. The iron powder particles are particles for intentionally forming a minute short circuit portion that forms a conductive path between the positive electrode 21 and the negative electrode 22.

As a result of the comparison in the comparison step S13, for example, if the voltage drop rate R is not less than the determination threshold value Rth (R≥Rth), it can be determined that a minute short circuit has occurred in the battery 100 showing such a voltage drop rate R. As a result of the comparison in the comparison step S13, for example, if the voltage drop rate R is less than the determination threshold value Rth (R<Rth), it may be determined that no minute short circuit has occurred in the battery 100 showing such a voltage drop rate R. On the basis of the result of the comparison in the comparison step S13, it is determined whether or not the next cutting step S2 is implemented. In addition to the result of the comparison performed in the comparison step S13, the value of the voltage drop rate R itself may be taken into consideration to determine whether or not the next cutting step S2 is implemented. For example, even if the voltage drop rate R is less than the determination threshold value Rth (R<Rth), when the degree of drop is small, the next cutting step S2 may be implemented.

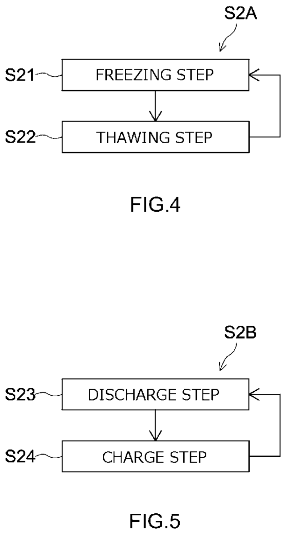

In the cutting step S2, when the minute short circuit portion is formed between the positive electrode 21 and the negative electrode 22 inside the electrode body 20, the minute short circuit is cut by changing the inter-electrode distance between the positive electrode 21 and the negative electrode 22. An example of the minute short circuit portion is a deposit portion such as a metal deposit portion formed by deposition from the non-aqueous electrolytic solution during repeated charging and discharging of the battery 100 that has already been assembled. The minute short circuit portion may be formed by chips of the electrode in the electrode body 20, impurities contained in the active material, dust mixed in during the battery manufacturing process, or the like, or may be substances derived from these materials. The inter-electrode distance is a length between a surface of the positive electrode active material layer 21a and a surface of the negative electrode active material layer 22a that face each other, in the positive electrode 21 and the negative electrode 22 adjacent to each other with the separator 23 interposed therebetween. The cutting step S2 in this embodiment is at least one selected from the group consisting of a cryogenic temperature process S2A (FIG. 4), a large-current charge/discharge process S2B (FIG. 5), and a low SOC process S2C described below.

The cryogenic temperature process S2A includes at least one cycle including a freezing step S21 and a thawing step S22, as shown in FIG. 4. The freezing step S21 is a step for freezing the non-aqueous electrolytic solution housed in the case 10 of the battery 100. The freezing of the non-aqueous electrolytic solution is useful to expand the non-aqueous electrolytic solution and increase (expand) the inter-electrode distance between the positive electrode 21 and the negative electrode 22. The thawing step S22 is a step for thawing the non-aqueous electrolytic solution frozen body. The thawing of the non-aqueous electrolytic solution frozen body to the non-aqueous electrolytic solution is useful to restore (reduce) the inter-electrode distance that has been expanded by the freezing step S21 to the original distance thereof. That is, one cycle including the freezing step S21 and the subsequent thawing step S22 is useful to increase or decrease (change) the inter-electrode distance.

Specifically, in the freezing step S21, the battery 100 is held at a temperature (first temperature) capable of freezing the non-aqueous electrolytic solution. The first temperature is preferably not more than -40°C, more preferably not more than -45°C, or may be not more than -50°C or not more than -60°C, in accordance with the type and composition of the non-aqueous electrolytic solution adopted into the battery 100. The first temperature is, for example, not less than -70°C. The holding time at the first temperature is preferably not less than 1 hour, more preferably not less than 5 hours, and still more preferably not less than 7 hours, from the viewpoint of sufficient freezing of the non-aqueous electrolytic solution. The holding time at the first temperature is preferably not more than 20 hours, more preferably not more than 12 hours, and still more preferably not more than 10 hours, from the viewpoint of shortening the total time required for the present method.

In the cryogenic temperature process S2A, a pre-cooling step (not shown) may be implemented before the freezing step S21. In the pre-cooling step, the battery 100 is held at a temperature (pre-cooling temperature) at which the non-aqueous electrolytic solution does not freeze. Such a pre-cooling step is useful to avoid defects caused by rapid cooling of the battery 100 or electrode body 20. The pre-cooling temperature during the pre-cooling step is preferably not more than -20°C, and preferably not more than -40°C, as long as the non-aqueous electrolytic solution adopted into the battery 100 does not freeze. The holding time at the pre-cooling temperature is preferably not less than 0.5 hours, more preferably not less than 1 hour, and still more preferably not less than 2 hours. The holding time at the pre-cooling temperature is preferably not more than 10 hours, more preferably not more than 5 hours, and still more preferably not more than 3 hours, from the viewpoint of shortening the total time required for the present method. The rate of temperature drop from the pre-cooling temperature during the pre-cooling step to the first temperature during the freezing step S21 is preferably not less than 5°C/min, more preferably not less than 8°C/min, and preferably not more than 12°C/min, more preferably not more than 10°C/min.

Specifically, in the thawing step S22, the battery 100 is held at a temperature (second temperature) capable of thawing the non-aqueous electrolytic solution. The second temperature is preferably not less than -20°C, more preferably not less than -10°C, or may be not less than 0°C or not less than 5°C, in accordance with the type and composition of the non-aqueous electrolytic solution adopted into the battery 100. The second temperature is, for example, not more than 50°C, not more than 30°C, or not more than 15°C. The thawing step S22 may include a plurality of thawing sub-steps in which the holding temperature is set to a gradually higher temperature. The holding time at the second temperature is preferably not less than 0.5 hour, more preferably not less than 1 hour, and still more preferably not less than 3 hours, from the viewpoint of sufficient thawing of the non-aqueous electrolytic solution. The holding time at the second temperature is preferably not more than 10 hours, more preferably not more than 7 hours, and still more preferably not more than 4 hours, from the viewpoint of shortening the total time required for the present method. When the thawing step S22 includes the plurality of thawing sub-steps, the above-described holding time is the total holding time of all the thawing sub-steps. The rate of temperature rise from the first temperature during the freezing step S21 to the second temperature during the thawing step S22 is preferably not less than 0.3°C/min, more preferably not less than 0.5°C/min, and preferably not more than 5.0°C/min, more preferably not more than 3.0°C/min.

The cryogenic temperature process S2A preferably includes a plurality of the above-described one cycle (freezing step S21, thawing step S22). The number of cycles of the cryogenic temperature process S2A is preferably not less than 2, more preferably not less than 3.

As shown in FIG. 5, the large-current charge/discharge process S2B includes at least one cycle including a large-current discharge step S23 and a large-current charge step S24 in the battery 100. The discharging of the battery 100 at a large current is useful to expand the positive electrode 21 (Li ions are inserted thereinto due to the discharge) and contract the negative electrode 22 (Li ions are removed therefrom due to the discharge), and is also useful to raise the temperature inside the electrode body 20, thereby dissolving at least a portion of the minute short circuit portion. The charging of the battery 100 at a large current is useful to contract the positive electrode 21 (Li ions are removed therefrom due to the charge) and expand the negative electrode 22 (Li ions are inserted thereinto due to the charge), and is also useful to raise the temperature inside the electrode body 20, thereby dissolving at least a portion of the minute short circuit portion. Such one cycle including the large-current discharge step S23 and the large-current charge step S24 is useful to change the inter-electrode distance.

In the large-current charge/discharge process S2B, a state-of-charge adjustment step (not shown) may be implemented before the first discharge step S23. In the state-of-charge adjustment step, the state of charge of the battery 100 is adjusted. The state of charge (SOC) of the battery 100 after the adjustment in the state-of-charge adjustment step is preferably not less than 30%, more preferably not less than 50%, and is, for example, not more than 100%, preferably not more than 80%.

The currents in the discharge step S23 and the charge step S24 are, when expressed in terms of charge/discharge rate, not less than 10 C, preferably not less than 12 C, and more preferably not less than 15 C. The current, when expressed in terms of current value, is not less than 100 A, preferably not less than 130 A, and more preferably not less than 150 A. These configurations are preferable for realizing a relatively large volume change regarding the positive electrode 21 and the negative electrode 22 and are also preferable for increasing the temperature inside the electrode body 20.

The state of discharge (i.e., SOC) reached in the discharge step S23 is preferably not more than 20%, more preferably not more than 10%, and still more preferably not more than 5%, and may be, for example, 0% or 3%. The state of charge (SOC) reached in the charge step S24 is preferably not less than 40%, more preferably not less than 50%, and still more preferably not less than 60%, and may be, for example, 90% or 70%.

The temperature at which the large-current charge/discharge process S2B is implemented is preferably not less than 10°C, more preferably not less than 18°C, still more preferably not less than 23°C, and is preferably not more than 40°C, more preferably not more than 30°C, still more preferably not more than 27°C.

The large-current charge/discharge process S2B preferably includes a plurality of the above-described one cycle (discharge step S23, charge step S24). The number of cycles of the large-current charge/discharge process S2B is preferably not less than 3, more preferably not less than 10, still more preferably not less than 20, and even more preferably not less than 30.

The low SOC process S2C includes holding the battery 100 in a low state of charge for extended periods of time. The holding of the battery 100 in the low state of charge for extended periods of time is useful to significantly increase the inter-electrode distance in the electrode body 20. The low state of charge (SOC) of the battery 100 in the low SOC process S2C is not more than 10%, preferably not more than 7%, more preferably not more than 5%, and may be, for example, not less than 0% or not less than 1%. The holding time of the battery 100 in the low SOC process S2C is not less than 24 hours, preferably not less than 48 hours, and more preferably not less than 72 hours, from the viewpoint of sufficient expansion of the inter-electrode distance. The holding time of the same is preferably not more than 168 hours, more preferably not more than 120 hours, and still more preferably not more than 96 hours, from the viewpoint of shortening the total time required for the present method.

The temperature at which the low SOC process S2C is implemented is preferably not less than 10°C, more preferably not less than 18°C, and still more preferably not less than 23°C. The higher the temperature is, the more easily the metals constituting the minute short circuit portion dissolve in the electrolytic solution, making it preferable.

When the cutting step S2 includes two types of processes among the above-described cryogenic temperature process S2A, large-current charge/discharge process S2B, and low SOC process S2C, the cutting step S2 specifically includes the process S2A and the subsequent process S2B, the process S2B and the subsequent process S2A, the process S2B and the subsequent process S2C, the process S2C and the subsequent process S2B, the process S2C and the subsequent process S2A, or the process S2A and the subsequent process S2C. When the cutting step S2 includes three kinds of processes, the cutting step S2 specifically includes the process S2A, the subsequent process S2B and the subsequent process S2C; the process S2A, the subsequent process S2C and the subsequent process S2B; the process S2B, the subsequent process S2A and the subsequent process S2C; the process S2B, the subsequent process S2C and the subsequent process S2A; the process S2C, the subsequent process S2A and the subsequent process S2B; or the process S2C, the subsequent process S2B and the subsequent process S2A. Preferably the cutting step S2 includes the cryogenic temperature process S2A, the cryogenic temperature process S2A and the subsequent large-current charge/discharge process S2B, or the large-current charge/discharge process S2B and the subsequent cryogenic temperature process S2A.

The post-check step S3 is a step for post-checking whether or not there is a minute short circuit in the battery 100 having undergone the cutting step S2, and is implemented after the cutting step S2. This check can be implemented, for example, by the voltage measurement step S11, the voltage drop rate calculation step S12, and the comparison step S13, which are similar to those described above regarding the pre-check step S1. Other methods may be adopted for check implemented in the post-check step S3. Alternatively, the post-check step S3 may not be implemented.

In the cutting step S2 of the secondary battery processing method, the minute short circuit portion extending between electrodes (the positive electrode 21 and the negative electrode 22) inside the electrode body 20 is cut by changing the inter-electrode distance between the positive electrode 21 and the negative electrode 22. Such a cutting step S2 is suitable for interrupting a conductive path formed, due to the minute short circuit portion, between electrodes (the positive electrode 21 and the negative electrode 22) by cutting the minute short circuit portion. Such an interruption of the conductive path is suitable for eliminating the minute short circuit in the battery 100 that has already been assembled.

Such a secondary battery processing method can be implemented in the manufacturing process of the battery cells. For example, in the manufacturing process of the battery 100, the above-described secondary battery processing method is implemented after a battery preparation step. The battery preparation step includes, for example, a step of fabricating the above-described electrode body 20, and a step of housing the electrode body 20 and the non-aqueous electrolytic solution in the case 10 to fabricate the assembly body of the battery 100. Such a secondary battery manufacturing method includes a step of cutting a minute short circuit portion extending between the positive electrode 21 and the negative electrode 22 inside the electrode body 20 by changing the inter-electrode distance between the positive electrode 21 and the negative electrode 22 (specifically, the above-described cutting step S2), and is positioned as a secondary battery manufacturing method according to one embodiment of the present invention.

The above-described secondary battery processing method may be implemented in the manufacturing process of a battery module (cell module) including a plurality of battery cells, or may be implemented in the manufacturing process of a plurality of battery packs (cell packs). Moreover, the above-described secondary battery processing method may be implemented as a reproduction process of used battery cells, battery modules, and the battery packs.

As described above, the cryogenic temperature process S2A includes at least one cycle including freezing (freezing step S21) and thawing (thawing step S22) of the non-aqueous electrolytic solution. One cycle including the freezing step S21 and the subsequent thawing step S22 is useful to increase or decrease (change) the inter-electrode distance between the positive electrode 21 and the negative electrode 22 inside the electrode body 20, and the increase or decrease of the inter-electrode distance and its repetition are suitable for interrupting the above-described conductive path and eliminating the minute short circuit of the battery 100.

As described above, the large-current charge/discharge process S2B includes at least one cycle including discharging (discharge step S23) the battery 100 at a large current (a discharge rate of not less than 10 C or a current value of not less than 100 A) and charging (charge step S24) the battery 100 at a large current (a charge rate of not less than 10 C or a current value of not less than 100 A). One cycle including the discharge step S23 and the subsequent charge step S24 is useful to change the inter-electrode distance between the positive electrode 21 and the negative electrode 22 inside the electrode body 20, and the change in the inter-electrode distance and its repetition are suitable for interrupting the above-described conductive path and eliminating the minute short circuit of the battery 100.

As described above, the low SOC process S2C includes holding the battery at an SOC of not more than 10% for not less than 24 hours. This is useful to significantly increase and change the inter-electrode distance in the electrode body 20 and is therefore suitable for interrupting the conductive path and eliminating minute short circuits in the battery 100.

Moreover, in the above-described secondary battery processing method, the pre-check step S1 includes the above-described voltage measurement step S11, voltage drop rate calculation step S12, and comparison step S13. Such a pre-check step S1 is useful for determining whether or not the cutting step S2 needs to be implemented on the battery 100 or the degree of necessity for implementing the cutting step S2.

### [Test Example 1: Confirmation of Difference in Voltage Drop Depending on Presence or Absence of Minute Short Circuit]

### [Fabrication of Battery X1]

First, a battery X1 was fabricated as a battery cell in which no minute short circuit occurred inside the electrode body. Specifically, it is as follows.

### [Fabrication of Positive Electrode]

First, a positive electrode current collector, and a positive electrode slurry for forming a positive electrode active material layer were prepared. The positive electrode current collector was long sheet-shaped aluminum foil (13 µm in thickness). The positive electrode slurry was obtained by kneading a mixture containing lithium nickel cobalt manganese composite oxide (LNCM) as a positive electrode active material, acetylene black (AB) as a conductive material, and polyvinylidene fluoride (PVDF) as a binder in a mass ratio of LNCM:AB:PVDF=87:10:3, and further containing a predetermined amount of N-methyl-2-pyrrolidone (NMP) as a solvent. Next, the positive electrode slurry was applied to a predetermined region (strip-shaped) on one surface of the positive electrode current collector (long sheet-shaped) to form a coating film, and then the coating film was dried. Subsequently, the positive electrode slurry was applied to a predetermined region (strip-shaped) on the other surface of the positive electrode current collector to form a coating film, and then the coating film was dried. In this way, positive electrode active material layers were formed on both sides of the positive electrode current collector. Next, the positive electrode current collector, on which the positive electrode active material layers were formed, was rolled using a pressure roller so that the thickness of each positive electrode active material layer became down to 30 µm. Next, the positive electrode current collector, on which the positive electrode active material layers were formed, was cut into a predetermined shape. In this way, a positive electrode sheet (positive electrode active material layer / positive electrode current collector / positive electrode active material layer) was fabricated.

This positive electrode sheet has an edge (first edge), at one end in the width direction, that linearly extends over the entire longitudinal direction. The first edge is formed by linearly cutting the positive electrode current collector and the positive electrode active material layers on both sides of the positive electrode current collector in the sheet longitudinal direction. Moreover, the positive electrode sheet also has a plurality of tabs (tabs 21t in FIG. 2) on the other side in the width direction at predetermined intervals in the longitudinal direction, and has an edge (second edge) that linearly extends in the longitudinal direction between the tabs. In the width direction, the edge of the positive electrode active material layer (linearly extending in the longitudinal direction) is positioned at a position receded from the second edge.

### [Fabrication of Negative Electrode]

First, a negative electrode current collector, and a negative electrode slurry for forming a negative electrode active material layer were prepared. The negative electrode current collector was long sheet-shaped copper foil (8 µm in thickness). The negative electrode slurry was obtained by kneading graphite as a negative electrode active material, styrene butadiene rubber (SBR) as a binder, and carboxymethyl cellulose (CMC) as a thickener in ion-exchanged water in a mass ratio of graphite:SBR:CMC=98:1:1. Next, the negative electrode slurry was applied to a predetermined region (strip-shaped) on one surface of the negative electrode current collector (long sheet-shaped) to form a coating film, and then the coating film was dried. Subsequently, the negative electrode slurry was applied to a predetermined region (strip-shaped) on the other surface of the negative electrode current collector to form a coating film, and then the coating film was dried. In this way, negative electrode active material layers were formed on both sides of the negative electrode current collector. Next, the negative electrode current collector, on which the negative electrode active material layers were formed, was rolled using a pressure roller so that the thickness of each negative electrode active material layer became down to 30 µm. Next, the negative electrode current collector, on which the negative electrode active material layers were formed, was cut into a predetermined shape. In this way, a negative electrode sheet (negative electrode active material layer / negative electrode current collector / negative electrode active material layer) was fabricated.

This negative electrode sheet also has a plurality of tabs (tabs 22t in FIG. 2) on one side in the width direction at predetermined intervals in the longitudinal direction, and has an edge (first edge) that linearly extends in the longitudinal direction between the tabs. This negative electrode sheet has an edge (second edge), at the other end in the width direction, that linearly extends over the entire longitudinal direction. The first and second edges are formed by linearly cutting the negative electrode current collector and the negative electrode active material layers on both sides of the negative electrode current collector in the sheet longitudinal direction.

### [Fabrication of Electrode Body]

First, a long sheet-shaped separator (two rolls) was prepared in addition to the above-described positive electrode sheet and negative electrode sheet. The separator had a two-layer structure of a polyethylene substrate / heat resistant layer and was 18 µm in thickness. Next, a long sheet-like laminated body in which the positive electrode sheet, the separator, the negative electrode sheet, and further separator were arranged in this order was wound to obtain a wound body (in the laminated body, the heat resistant layer of the separator and the positive electrode active material layer of the positive electrode sheet were in contact with each other). The number of turns in the wound body was 66. Next, the wound body was pressed to be flattened. In this way, a flat wound electrode body was fabricated (approximately 6 cm (length in the winding axis direction) × approximately 11.5 cm × thickness 10.6 mm).

### [Assembly of Battery Cell]

First, an aluminum case body (case body 11 in FIG. 1) and a sealing plate provided with terminals were prepared, in addition to the above-described wound electrode body. The sealing plate provided with terminals was an aluminum sealing plate (sealing plate 12 in FIG. 1) to which a positive electrode terminal (positive electrode terminal 30 in FIG. 1) and a negative electrode terminal (negative electrode terminal 40 in FIG. 1) were attached by caulking. Next, the plurality of tabs of the positive electrode in the wound electrode body were connected to an aluminum positive electrode current collector plate by laser welding, and the plurality of tabs of the negative electrode were connected to a copper negative electrode current collector plate by laser welding. Next, the inside of the case of the positive electrode terminal of the sealing plate provided with terminals was connected to the positive electrode current collector plate by laser welding, and the inside of the case of the negative electrode terminal of the sealing plate provided with terminals was connected to the negative electrode current collector plate by laser welding. In this way, an assembly body was obtained including the wound electrode body and the sealing plate provided with terminals. Next, the wound electrode body and both electrode current collector plates of this assembly body were inserted into the case body, and the opening of the case body was sealed with the sealing plate provided with terminals, and then the case body and the sealing plate were laser welded around the entire periphery of the opening. Next, the electrolytic solution was injected into the case through the liquid injection hole of the sealing plate, and then the liquid injection hole was sealed. The non-aqueous electrolytic solution contained a mixed solvent of ethylene carbonate (EC), ethyl methyl carbonate (EMC), and dimethyl carbonate (DMC) (EC:EMC:DMC=30:30:40 [volume ratio]), and LiPF₆ (concentration of 1.15 mol/L) as an electrolyte to be dissolved therein. In this way, the battery X1 was fabricated as a secondary battery (lithium ion battery).

### [Fabrication of Battery X2]

On the other hand, a battery X2 was fabricated as a battery cell in which a minute short circuit occurred inside the electrode body. Specifically, the Battery X2 was fabricated in the same manner as the Battery X1, except that two iron powder particles (particle size of 30 µm) were inserted between the positive electrode active material layer of the positive electrode sheet and the separator during the electrode body fabrication process. The iron powder particles were particles for forming a conductive path between the electrodes of the electrode body, in imitation of the above-described minute short circuit portion.

### [Voltage Measurement Step]

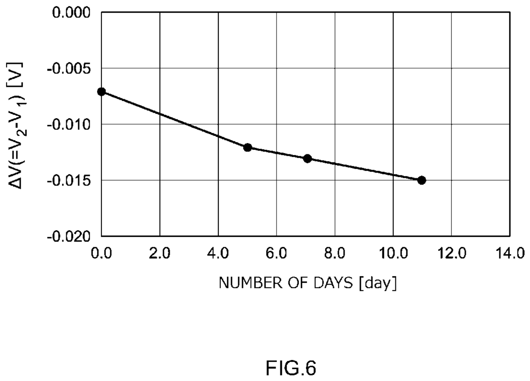

The batteries X1 and X2 were left to stand in an open circuit state under the same conditions. Specifically, before the start of the standing, the state of charge (SOC) of the batteries (battery X1, battery X2) was adjusted to 80%, and then the batteries were left to stand in an environment of 25°C. Then, at the start of leaving the batteries to stand and at 5, 7 and 11 days after leaving the batteries to stand, the voltage V₁ of the battery X1 and the voltage V₂ of the battery X2 were measured as open circuit voltages (OCV). The difference ΔV (=V₂-V₁) between the voltage V₁ and the voltage V₂ was obtained at each measurement time point. FIG. 6 shows the results in the graph. In the graph of FIG. 6, the horizontal axis indicates the number of days elapsed since the battery was left to stand, and the vertical axis indicates the difference ΔV. As shown in the graph of FIG. 6, the difference ΔV between the voltage V₁ of the battery X1 and the voltage V₂ of the battery X2 continued to increase over time. That is, a significant voltage drop (approximately 0.73 mV/day) occurred in the battery X2 as compared with the battery X1. This voltage drop was due to the minute short circuit occurring inside the electrode body of the battery X2.

### [Test Example 2: Confirmation of Effect of Cryogenic Temperature Process]

First, the batteries X1 and X2 were prepared similarly to the above-described Test Example 1. Next, the batteries X1 and X2 were subjected to a cryogenic temperature process (cryogenic temperature process S2A in the above-described embodiment).

Specifically, in the cryogenic temperature process, one cycle including the predetermined steps was repeated three times with respect to the batteries X1 and X2. The one cycle included leaving the sample at -30°C for 2 hours (step 1: pre-cooling step), leaving the sample at -45°C for 8 hours (step 2: freezing step), leaving the sample at -10°C for 2 hours (step 3: part of the thawing step), and leaving the sample at 5°C for 2 hours (step 4: part of the thawing step), in this order. During the one cycle, the temperature drop rate when transitioning to the next step was set to 8°C/min, and the temperature rise rate when transitioning to the next step was set to 0.5°C/min.

After such a cryogenic temperature process, the voltage measurement step was applied to the batteries X1 and X2 in the same manner as described above for Test Example 1. Then, the difference ΔV (=V₂-V₁) between the voltage V₁ and the voltage V₂ was obtained at each measurement time point.

In accordance with the result thereof, the difference ΔV was not increased over time. Specifically, the voltage drop of the Battery X2 was within 0.001 mV/day as compared with the Battery X1 up to 7.75 days after the start of leaving to stand. That is, the battery X2 (with the minute short circuit) that was not subjected to the cryogenic temperature process experienced a voltage drop as shown in FIG. 6, while the battery X2 that was subjected to the cryogenic temperature process did not experience such a voltage drop. This means that the cryogenic temperature process is effective for eliminating the minute short circuit in the battery X2.

### [Test Example 3: Confirmation of Effect of Large-Current Charge/Discharge Process]

First, the batteries X1 and X2 were prepared similarly to the above-described Test Example 1. Next, the batteries X1 and X2 were subjected to a large-current charge/discharge process (large-current charge/discharge process S2B in the above-described embodiment).

Specifically, in the large-current charge/discharge process, the state of charge (SOC) of each of the batteries X1 and X2 was adjusted to 50%, and then the batteries were left to stand at 25°C for 10 minutes, and then one cycle including the predetermined steps was repeated 30 times. The one cycle included discharging at 150 A for 10 seconds (discharge step), and subsequent charging at 150 A for 10 seconds (charge step).

After such a large-current charge/discharge process, the voltage measurement step was applied to the batteries X1 and X2 in the same manner as described above for Test Example 1. Then, the difference ΔV (=V₂-V₁) between the voltage V₁ and the voltage V₂ was obtained at each measurement time point.

In accordance with the result thereof, the difference ΔV was not increased over time. Specifically, the voltage drop of the Battery X2 was within 0.001 mV/day as compared with the Battery X1 up to 12 hours after the start of leaving to stand. That is, the battery X2 (with the minute short circuit) that was not subjected to the large-current charge/discharge process experienced a voltage drop as shown in FIG. 6, while the battery X2 that was subjected to the large-current charge/discharge process did not experience such a voltage drop. This means that the large-current charge/discharge process is effective for eliminating the minute short circuit in the battery X2.

### [Test Example 4: Confirmation of Effect of Low SOC Process]

First, the batteries X1 and X2 were prepared similarly to the above-described Test Example 1. Next, the batteries X1 and X2 were subjected to a low SOC process (low SOC process S2C in the above-described embodiment). Specifically, the state of charge (SOC) of the batteries X1 and X2 was adjusted to 5% and then were left to stand at 25°C for 72 hours. Next, the voltage measurement step was implemented on the batteries X1 and X2 after the low SOC process in the same manner as described above in relation to Test Example 1. Then, the difference ΔV (=V₂-V₁) between the voltage V₁ and the voltage V₂ was obtained at each measurement time point.

In accordance with the result thereof, the difference ΔV was not increased over time. Specifically, the voltage drop of the Battery X2 was within 0.001 mV/day as compared with the Battery X1 up to 4.75 days after the start of leaving to stand. That is, the battery X2 (with the minute short circuit) that was not subjected to the low SOC process experienced a voltage drop as shown in FIG. 6, while the battery X2 that was subjected to the low SOC process did not experience such a voltage drop. This means that the low SOC process is effective for eliminating the minute short circuit in the battery X2.

The technology disclosed herein has been described in various ways. Unless otherwise specified, the present invention is not limited to the embodiments and the like described herein. Moreover, the technology disclosed herein can be modified in various ways, and as long as no particular problem arises, the components and processes mentioned herein can be omitted or combined as appropriate. Moreover, the present specification also includes the disclosures as claimed in each of the following sections.

### Section 1:

A method for processing a secondary battery, the secondary battery comprising an electrode body, a non-aqueous electrolytic solution, and a case housing the electrode body and the non-aqueous electrolytic solution,
the electrode body including a laminated structure of a positive electrode, a negative electrode, and a separator interposed between the positive electrode and the negative electrode,
the method comprising a cutting step of cutting a minute short circuit portion extending between the positive electrode and the negative electrode inside the electrode body by changing an inter-electrode distance between the positive electrode and the negative electrode.

### Section 2:

The method for processing the secondary battery according to Section 1, wherein the cutting step includes at least one cycle including freezing and thawing the non-aqueous electrolyte solution.

### Section 3:

The method for processing the secondary battery according to Section 1 or 2, wherein the cutting step includes at least one cycle including discharging the battery at a discharge rate of not less than 10 C and charging the battery at a charge rate of not less than 10 C.

### Section 4:

The method for processing the secondary battery according to any one of Sections 1-3, wherein the cutting step includes at least one cycle including discharging the battery at a current value of not less than 100 A and charging the battery at a current value of not less than 100 A.

### Section 5:

The method for processing the secondary battery according to any one of Sections 1-4, wherein the cutting step includes holding the battery at an SOC of not more than 10% for not less than 24 hours.

### Section 6:

The method for processing the secondary battery according to any one of Sections 1-5, further comprising a pre-check step before the cutting step, wherein
the pre-check step includes
implementing multiple voltage measurements on the battery,
calculating a voltage drop rate on the basis of a plurality of voltage values obtained by the multiple voltage measurements, and
comparing the voltage drop rate with a determination threshold value.

### Section 7:

A method for manufacturing a secondary battery, comprising the method for processing the secondary battery according to any one of Sections 1-6.

## Claims

1. A method for processing a secondary battery (100), the secondary battery (100) comprising an electrode body (20), a non-aqueous electrolytic solution, and a case (10) housing the electrode body (20) and the non-aqueous electrolytic solution,
the electrode body (20) including a laminated structure of a positive electrode (21), a negative electrode (22), and a separator (23) interposed between the positive electrode (21) and the negative electrode (22),
the method comprising a cutting step (S2) of cutting a minute short circuit portion extending between the positive electrode (21) and the negative electrode (22) inside the electrode body (20) by changing an inter-electrode distance between the positive electrode (21) and the negative electrode (22).

2. The method for processing the secondary battery (100) according to claim 1, wherein the cutting step (S2) includes at least one cycle including freezing and thawing the non-aqueous electrolyte solution.

3. The method for processing the secondary battery (100) according to claim or 1, wherein the cutting step (S2) includes at least one cycle including discharging the battery at a discharge rate of not less than 10 C and charging the battery at a charge rate of not less than 10 C.

4. The method for processing the secondary battery (100) according to claim or 1, wherein the cutting step (S2) includes at least one cycle including discharging the battery at a current value of not less than 100 A and charging the battery at a current value of not less than 100 A.

5. The method for processing the secondary battery (100) according to any one of claims 1 to 4, wherein the cutting step (S2) includes holding the battery at an SOC of not more than 10% for not less than 24 hours.

6. The method for processing the secondary battery (100) according to any one of claims 1 to 5, further comprising a pre-check step (S1) before the cutting step (S2), wherein
the pre-check step (S1) includes
implementing multiple voltage measurements on the battery,
calculating a voltage drop rate on the basis of a plurality of voltage values obtained by the multiple voltage measurements, and
comparing the voltage drop rate with a determination threshold value.

7. A method for manufacturing a secondary battery (100), comprising the method for processing the secondary battery (100) according to any one of claims 1 to 6.
